# EUROPEAN PATENT APPLICATION

(11) **EP 4 053 911 A1**
(43) Date of publication of application: **07.09.2022**
(21) Application number: 22159689.3
(22) Date of filing: 02.03.2022
(51) Int. Cl.: H01L 29/417, H01L 29/423

(54) **SEMICONDUCTOR DEVICE**

(30) Priority: 05.03.2021 JP 2021034898; 21.10.2021 JP 2021172416
(71) Applicant: Sumitomo Electric Device Innovations, Inc., Yokohama-shi, Kanagawa, 224-0845 (JP)
(72) Inventor: Matsumoto, Takuya, Yokohama-shi, 244-0845 (JP)
(74) Representative: Grünecker Patent- und Rechtsanwälte PartG mbB

(57) **Abstract**

A semiconductor device includes a substrate, a first source finger, a first gate finger, a first drain finger, a second source finger, a second gate finger, a second drain finger, a first gate wiring, wherein a width of the first gate wiring in the extension direction at a first region where the first gate finger connects to the first gate wiring is smaller than a width of the first gate wiring in the extension direction at a second region located between the first source finger and the second source finger, and an end of the first region near the second gate finger in the extension direction is located closer to the second gate finger than an end of the second region near the second gate finger in the extension direction.

## Description

### FIELD

The present disclosure relates to a semiconductor device, for example, a semiconductor device having a field effect transistor.

### BACKGROUND

In the field effect transistor (FET) having a source, a gate and a drain, it is known to arrange a plurality of unit FETs having a source finger, a gate finger and a drain finger in an extension direction of the fingers (e.g., Patent Document 1: Japanese Laid-open Patent Publication No. 2002-299351).

### SUMMARY

A semiconductor device according to the present disclosure includes a substrate; a first source finger provided on the substrate; a first gate finger provided adjacent to the first source finger in a width direction of the first source finger, and on the substrate along the first source finger; a first drain finger provided on the substrate and sandwiching the first gate finger between the first source finger and the first drain finger; a second source finger provided on a region of the substrate located in an extension direction of the first source finger from the first source finger, and extending in the extension direction; a second gate finger provided adjacent to the second source finger in the width direction of the second source finger, on a region of the substrate located in the extension direction from the first gate finger, and along the second source finger; a second drain finger provided on the substrate and sandwiching the second gate finger between the second source finger and the second drain finger; and a first gate wiring provided on the substrate, connected to a first end of the first gate finger, not connected to the second gate finger, and extending in the width direction; wherein a width of the first gate wiring in the extension direction at a first region where the first gate finger connects to the first gate wiring is smaller than a width of the first gate wiring in the extension direction at a second region located between the first source finger and the second source finger, and an end of the first region near the second gate finger in the extension direction is located closer to the second gate finger than an end of the second region near the second gate finger in the extension direction.

### BRIEF DESCRIPTION OF DRAWINGS

FIG. 1 is a plan view illustrating a semiconductor device according to a first embodiment.
FIG. 2 is a cross-sectional view taken along line A-A of FIG. 1.
FIG. 3 is a cross-sectional view taken along line B-B of FIG. 1.
FIG. 4 is a cross-sectional view taken along line C-C of FIG. 1.
FIG. 5 is a cross-sectional view taken along line D-D of FIG. 1.
FIG. 6 is a plan view illustrating active regions, an ohmic metal layer, and a gate metal layer in the semiconductor device according to the first embodiment.
FIG. 7 is an enlarged plan view illustrating the semiconductor device according to the first embodiment.
FIG. 8 is an enlarged plan view illustrating the semiconductor device according to a first comparative example.
FIG. 9 is an enlarged plan view illustrating the semiconductor device according to a first variation of the first embodiment.
FIG. 10 is an enlarged plan view illustrating the semiconductor device according to a second variation of the first embodiment.
FIG. 11 is a plan view illustrating the active regions, the ohmic metal layer, and the gate metal layer in the semiconductor device according to a second embodiment.

### DETAILED DESCRIPTION OF EMBODIMENTS

In Patent Document 1, the plurality of unit FETs are arranged in the extension direction of the fingers, so that the gate finger in the unit FET can be shortened.

However, when the gate fingers of the unit FETs adjacent to each other in the extension direction are connected to the same gate wiring, the high-frequency characteristics may be degraded. When the gate finger of one of the adjacent unit FETs is connected to the gate wiring and the gate finger of the other of the adjacent unit FETs is not connected to the gate wiring, an interval between the adjacent unit FETs cannot be reduced. Therefore, the semiconductor device increases in size.

It is an object of the present disclosure to provide a semiconductor device that can be reduced in size.

### [Description of Embodiments of the Present Disclosure]

First, the contents of the embodiments of this disclosure are listed and explained.

### [Details of Embodiments of the Present Disclosure]

(1) A semiconductor device according to the present disclosure includes a substrate; a first source finger provided on the substrate; a first gate finger provided adjacent to the first source finger in a width direction of the first source finger, and on the substrate along the first source finger; a first drain finger provided on the substrate and sandwiching the first gate finger between the first source finger and the first drain finger; a second source finger provided on a region of the substrate located in an extension direction of the first source finger from the first source finger, and extending in the extension direction; a second gate finger provided adjacent to the second source finger in the width direction of the second source finger, on a region of the substrate located in the extension direction from the first gate finger, and along the second source finger; a second drain finger provided on the substrate and sandwiching the second gate finger between the second source finger and the second drain finger; and a first gate wiring provided on the substrate, connected to a first end of the first gate finger, not connected to the second gate finger, and extending in the width direction; wherein a width of the first gate wiring in the extension direction at a first region where the first gate finger connects to the first gate wiring is smaller than a width of the first gate wiring in the extension direction at a second region located between the first source finger and the second source finger, and an end of the first region near the second gate finger in the extension direction is located closer to the second gate finger than an end of the second region near the second gate finger in the extension direction. This makes it possible to provide the semiconductor device that can be reduced in size.
(2) A part of the second gate finger and a part of the first gate wiring may overlap each other when viewed from the width direction.
(3) The width of the first gate wiring in the extension direction gradually may increase from the first region to the second region.
(4) The semiconductor device further may include: a gate bus bar provided on the substrate and to which the second gate finger is connected; and a second gate wiring connecting the first gate wiring to the gate bus bar and extending in the extension direction.
(5) The second gate wiring and the second gate finger may sandwich the second source finger.
(6) A width of the second source finger may be smaller than a width of the first source finger, and a width of the second gate wiring in the width direction may be within the width of the first source finger.
(7) The semiconductor device further may include a via penetrating the substrate and connecting the first source finger to a metal layer provided under the substrate.
(8) The semiconductor device may further include: a source wiring connecting the first source finger to the second source finger, and intersecting the first gate wiring in a non-contact manner.
(9) The substrate may include a first active region in which a semiconductor layer inside the substrate is activated, a second active region in which the semiconductor layer inside the substrate is activated, the first active region and the second active region being separated from each other, and an inactive region provided between the first active region and the second active region and in which the semiconductor layer is deactivated. The first source finger, the first gate finger, and the first drain finger may be provided on the first active region, the second source finger, the second gate finger, and the second drain finger may be provided on the second active region, and the first gate wiring may be provided on the inactive region.
(10) The semiconductor device further may include: a third gate finger provided adjacent to the first source finger in a width direction of the first source finger, on the substrate along the first source finger, and sandwiching the first source finger between the first gate finger and the third gate finger; a third drain finger provided on the substrate and sandwiching the third gate finger between the first source finger and the third drain finger; a third source finger provided on the substrate, having a width smaller than the width of the first source finger, the width in the width direction being within the width of the first source finger, provided on the same side as the second source finger with respect to the first source finger, and extending in the extension direction; a fourth gate finger provided adjacent to the third source finger in the width direction of the third source finger, on the substrate in the extension direction of the third gate finger and extending in the extension direction; on a region of the substrate located in the extension direction from the third gate finger, and along the third source finger; a fourth drain finger provided on the substrate and sandwiching the fourth gate finger between the third source finger and the fourth drain finger; and a third gate wiring provided on the substrate, connected to the first end of the third gate finger, not connected to the fourth gate finger, and extending in the width direction; wherein a width of the third gate wiring in the extension direction at a third region where the third gate finger connects to the third gate wiring is smaller than a width of the third gate wiring in the extension direction at a fourth region located between the first source finger and the third source finger, and an end of the third region near the fourth gate finger in the extension direction is located closer to the third gate finger than an end of the fourth region near the fourth gate finger in the extension direction.

Specific examples of a semiconductor device in accordance with embodiments of the present disclosure are described below with reference to the drawings. The present disclosure is not limited to these examples, but is indicated by the claims, which are intended to include all modifications within the meaning and scope of the claims.

### (FIRST EMBODIMENT)

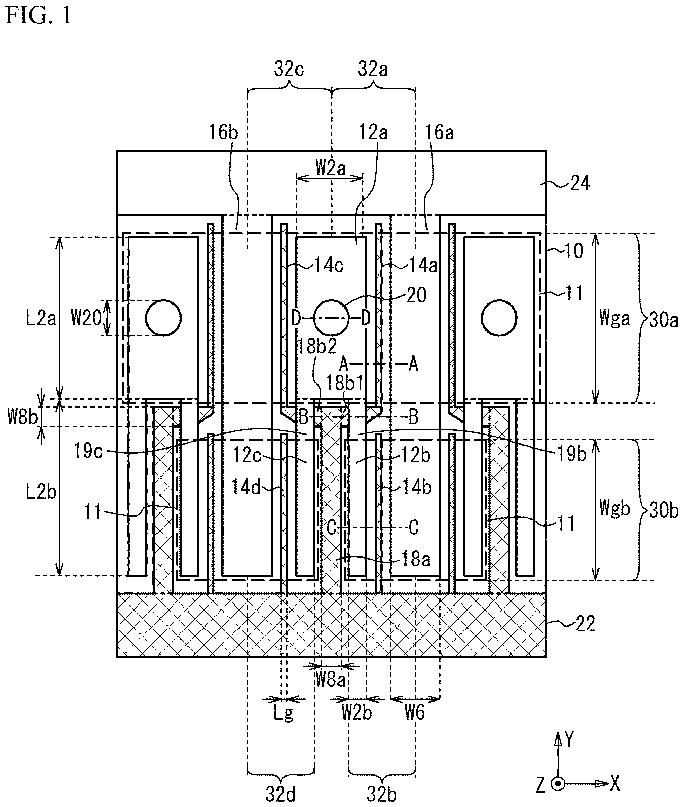

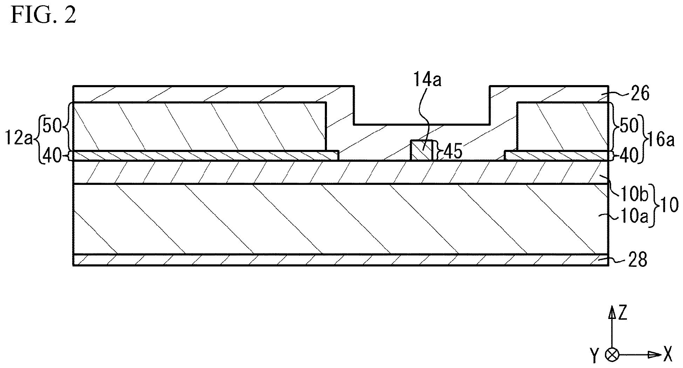

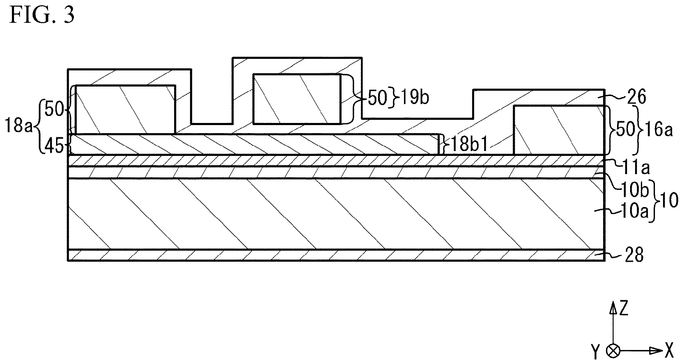

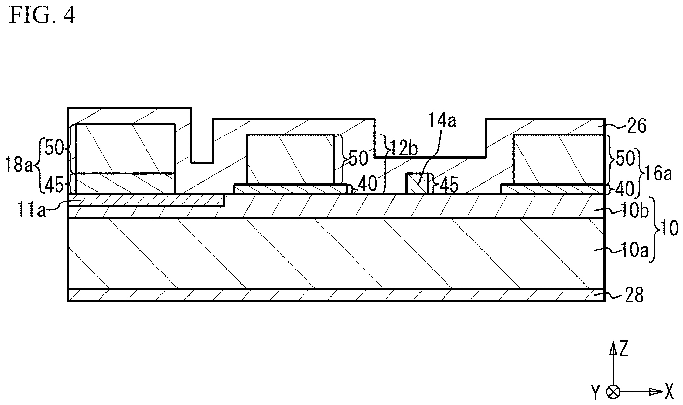

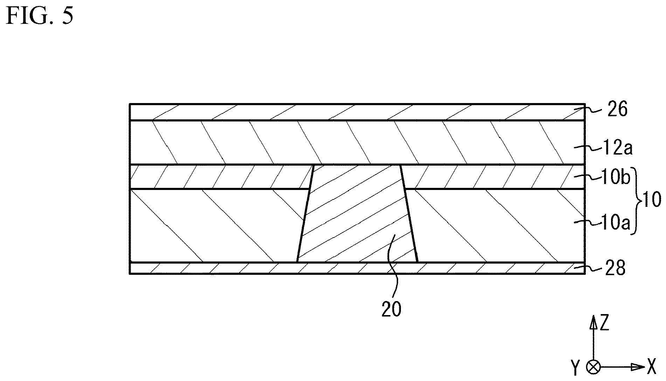

FIG. 1 is a plan view illustrating the semiconductor device according to a first embodiment. FIGs. 2 to 5 are cross-sectional views taken along lines A-A, B-B, C-C, D-D of FIG. 1, respectively. A normal direction of an upper surface of a substrate 10 is a Z direction, an extension direction of each finger is a Y direction, and a width direction of each finger is an X direction.

As illustrated in FIGs. 1 to 5, the substrate 10 includes a substrate 10a and a semiconductor layer 10b provided on the substrate 10a. A region where the semiconductor layer 10b is inactivated by ion implantation or the like is an inactive region 11a, and a region where it is not inactivated is an active region 11. Source fingers 12a to 12c, gate fingers 14a to 14d, drain fingers 16a and 16b, gate wirings 18a, 18b1 and 18b2, a gate bus bar 22, and a drain bus bar 24 are provided on the substrate 10.

Each of the source fingers 12a to 12c and the drain fingers 16a and 16b has an ohmic metal layer 40 provided on the active region 11 and a low resistance layer 50 provided on the ohmic metal layer 40. The ohmic metal layer 40 makes ohmic contact with the semiconductor layer 10b. The low resistance layer 50 has a lower resistivity and a larger thickness than the ohmic metal layer 40. The width in the X and Y directions of the ohmic metal layer 40 included in the source fingers 12a to 12c and drain fingers 16a and 16b may be greater than or equal to the width of the low resistance layer 50 in the X and Y directions. A source wiring 19b connects the source fingers 12a and 12b to each other, and a source wiring 19c connects the source fingers 12a and 12c to each other. Each of the source wirings 19b and 19c is provided on the inactive region 11a, has the low resistance layer 50, and does not have the ohmic metal layer 40. A portion of each of the drain fingers 16a and 16b on the inactive region 11a has the low resistance layer 50 and does not have the ohmic metal layer 40.

Each of the gate fingers 14a to 14d has a gate metal layer 45 on the active region 11 and does not have the low resistance layer 50. The gate wiring 18b1 has the gate metal layer 45 on the inactive region 11a and does not have the low resistance layer 50. The gate wiring 18a has the gate metal layer 45 and the low resistance layer 50 provided on the semiconductor layer 10b. The low resistance layer 50 has a lower resistivity and a larger thickness than the gate metal layer 45.

The source finger 12a extends in the Y direction and has a width W2a in the X direction and a length L2a in the Y direction. The source fingers 12b and 12c extend in the Y direction from both ends in the X direction of source finger 12a. Each of the source fingers 12b and 12c has a width W2b in the X direction and a length L2b in the Y direction. The drain finger 16a extending in the Y direction is provided at a position separated from the source fingers 12a and 12b by a predetermined distance in a +X direction. The drain finger 16b extending in the Y direction is provided at a position separated from the source fingers 12a and 12c by a predetermined distance in a -X direction. Each of the drain fingers 16a and 16b has a width W6 in the X direction. The gate fingers 14a and 14b are provided between the drain finger 16a and the source fingers 12a and 12b, and the gate fingers 14c and 14d are provided between the drain finger 16b and the source fingers 12a and 12c. Each of the gate fingers 14a to 14d extends in the Y direction, and the width thereof in the X direction corresponds to a gate length Lg.

The gate wiring 18a extending in the Y direction and having a width W8a in the X direction is provided between the source fingers 12b and 12c. The gate wirings 18b1 and 18b2 are provided between the gate fingers 14a and 14c, and the gate fingers 14b and 14d. The gate wirings 18b1 and 18b2 have a width W8b in the Y direction, extend in the X direction, and connect ends of the gate fingers 14a and 14c in a -Y direction to an end of the gate wiring 18a in a +Y direction. The gate wirings 18b and 12b2 and the source wirings 19b and 19c intersect through the insulating film 26 and are not electrically connected to each other. Ends of gate fingers 14b, 14d and the gate wiring 18a in the -Y direction are connected to the gate bus bar 22. Ends of the drain fingers 16a and 16b in the +Y direction are connected to the drain bus bar 24. The source finger 12a is connected to the metal layer 28 provided under the substrate 10 through vias 20 that penetrate the substrate 10. The insulating film 26 is provided so as to cover the source fingers 12a to 12c, the gate fingers 14a to 14d, the drain fingers 16a and 16b, and the gate wirings 18a, 18b 1 and 18b2.

FET regions 30a and 30b are arranged in the Y direction. In the FET region 30a, the active region 11 including the source finger 12a is extended in the X direction. The source finger 12a, the gate finger 14a, and the drain finger 16a form a unit FET 32a, and the source finger 12a, the gate finger 14c, and the drain finger 16b form a unit FET 32c. A gate width Wga of the unit FETs 32a and 32c corresponds to a length in the Y direction of the active region 11 including the source fingers 12a. A source potential of the unit FETs 32a and 32c is supplied from the metal layer 28 to the source finger 12a through the via 20. A gate potential (and a gate signal) is supplied from the gate bus bar 22 to the gate fingers 14a and 14c through the gate wirings 18a, 18b1 and 18b2. A drain potential is supplied from the drain bus bar 24 to the drain fingers 16a and 16b. The unit FETs 32a and 32c are arranged alternately in the X direction.

In the FET region 30b, the active region 11 is provided except for the gate wiring 18a. The source finger 12b, the gate finger 14b and the drain finger 16a form a unit FET 32b, and the source finger 12c, the gate finger 14d and the drain finger 16b form a unit FET 32d. A gate width Wgb of the unit FETs 32b and 32d corresponds to lengths in the Y direction of the active regions 11 including the source fingers 12b and 12c. The source potential of the unit FETs 32b and 32d is supplied from the metal layer 28 to the source fingers 12b and 12c through the via 20 and the source finger 12a. The gate potential (and the gate signal) is supplied from the gate bus bar 22 to the gate fingers 14b and 14d. The drain potential is supplied from the drain bus bar 24 to the drain fingers 16a and 16b. The unit FETs 32b and 32d are arranged alternately in the X direction. When the gate width of the entire semiconductor device is increased, a plurality of unit FETs 32a to 32d are arranged in the X direction.

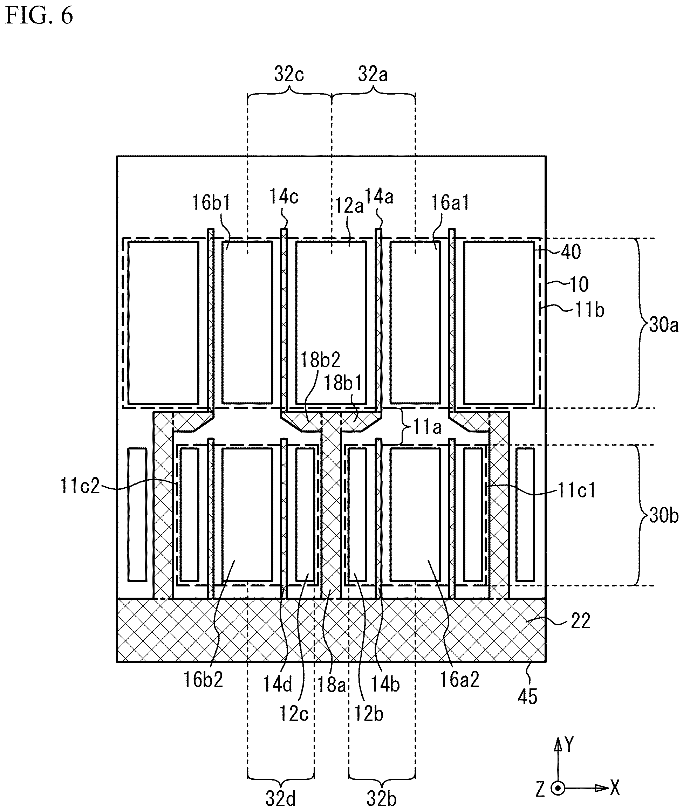

FIG. 6 is a plan view illustrating active regions 11b, 11c1 and 11c2, an ohmic metal layer 40, and a gate metal layer 45 in the semiconductor device according to the first embodiment. As illustrated in FIG. 6, the active region 11b is provided in the FET region 30a of the substrate 10, and the active regions 11c1 and 11c2 are provided in the FET region 30b. The source finger 12a and the drain fingers 16a1 and 16b1 are provided on the active region 11b by the ohmic metal layer 40, and the gate fingers 14a and 14c are provided by the gate metal layer 45. The source finger 12b and the drain finger 16a2 are formed on the active region 11c1 by the ohmic metal layer 40, and the gate finger 14b is formed by the gate metal layer 45. The source finger 12c and the drain finger 16b2 are formed on the active region 11c2 by the ohmic metal layer 40, and the gate finger 14d is formed by the gate metal layer 45. The drain fingers 16a1 and 16a2 are connected by the low resistance layer 50 to form the drain finger 16a in FIG. 1. The drain fingers 16b1 and 16b2 are connected by the low resistance layer 50 to form the drain finger 16b in FIG. 1.

In the unit FET 32a, the gate finger 14a (a first gate finger) is provided adjacent to the source finger 12a (a first source finger) in the X direction (width direction) of the source finger 12a. The drain finger 16a1 (a first drain finger) sandwiches the gate finger 14a between the source finger 12a and the drain finger 16a1. In the unit FET 32b, the source finger 12b (a second source finger) is provided in the -Y direction of the source finger 12a. The gate finger 14b (a second gate finger) is provided adjacent to the source finger 12b in the X direction of the source finger 12b, and provided in the -Y direction of the gate finger 14a. The drain finger 16a2 (a second drain finger) sandwiches the gate finger 14b between the source finger 12b and the drain finger 16a2. The gate wiring 18b1 (a first gate wiring) is connected to a first end (a -Y side end) of the gate finger 14a, is not connected to the gate finger 14b, and extends in the X direction.

In the unit FET 32c, the gate finger 14c (a third gate finger) sandwiches the source finger 12a between the gate finger 14a and the gate finger 14c. The drain finger 16b1 (a third drain finger) sandwiches the gate finger 14c between the source finger 12a and the drain finger 16b1. In the unit FET 32d, the source finger 12c (a third source finger) is provided on the same side as the source finger 12b with respect to the source finger 12a. The gate finger 14d (a fourth gate finger) is provided adjacent to the source finger 12c in the X direction of the source finger 12c, and provided in the -Y direction of the gate finger 14c. The drain finger 16b2 (a fourth drain finger) sandwiches the gate finger 14d between the source finger 12c and the drain finger 16b2. The gate wiring 18b2 (a third gate wiring) is connected to a first end (a -Y side end) of the gate finger 14c, is not connected to the gate finger 14d, and extends in the X direction.

The gate wiring 18b1 is provided on the inactive region 11a between the active regions 11b and 11c1. The gate wiring 18b2 is provided on the inactive region 11a between the active regions 11b and 11c2. The gate wiring 18a is provided on the inactive region 11a between the active regions 11c1 and 11c2. The first end (the -Y side end) of the gate fingers 14b, 14c and the gate wiring 18a is connected to the gate bus bar 22. The gate wiring 18b1 connects the gate finger 14a to the gate wiring 18a. The gate wiring 18b2 connects the gate finger 14c to the gate wiring 18a. The second ends (the +Y side ends) of the gate fingers 14b and 14d are not connected to the gate wirings 18b1 and 18b2.

When the semiconductor device is, for example, a nitride semiconductor device, the substrate 10a is, for example, a SiC substrate, a silicon substrate, a GaN substrate, or a sapphire substrate. The semiconductor layer 10b includes, for example, a nitride semiconductor layer such as GaN, AlGaN and/or InGaN layers. When the semiconductor device is, for example, a GaAs-based semiconductor device, the substrate 10a is, for example, a GaAs substrate. The semiconductor layer 10b includes an arsenide semiconductor layer such as GaAs layer, AlGaAs layer and/or InGaAs layer. The ohmic metal layer 40 is metal films, and includes, for example, an adhesion film (e.g., titanium film) and an aluminum film in this order from the substrate 10. The gate metal layer 45 is metal films, and includes, for example, an adhesion film (e.g., nickel film) and a gold film in this order from the substrate 10. The low resistance layer 50 is metal layers, and includes, for example, a barrier layer (e.g., titanium-tungsten film) and a gold film. The source fingers 12a to 12c and the drain fingers 16a and 16b may not be provided with the low resistance layer 50. The gate wiring 18a may not be provided with the gate metal layer 45. The gate bus bar 22 may have the gate metal layer 45 and the low resistance layer 50, or it may have the low resistance layer 50 and no gate metal layer 45. The drain bus bar 24 may have the ohmic metal layer 40 and the low resistance layer 50, or it may have the low resistance layer 50 and no ohmic metal layer 40. The via 20 and the metal layer 28 include, for example, the adhesion layer and the gold layer in this order from substrate 10. The insulating film 26 is, for example, a silicon nitride film.

The width W2a of the source finger 12a in the X direction is, for example, 50 to 100 µm, and the length L2a in the Y direction is, for example, 100 to 400 µm. The width W2b of the source fingers 12b and 12c in the X direction is, is, for example, 5 to 20 µm, and the length L2b in the Y direction is, for example, 110 to 410 µm. The gate length Lg of the gate fingers 14a to 14d in the X direction is, for example, 0.25 to 2 µm. The width W6 of the drain fingers 16a and 16b in the X direction is, for example, 5 to 100 µm. The width W8a of the gate wiring 18a is, for example, 5 to 20 µm. The width W8b of the gate wirings 18b1 and 18b2 is, for example, 5 to 20 µm. The gate width Wga of the unit FETs 32a and 32c is, for example, 100 to 400 µm, and the gate width Wgb of the unit FETs 32b and 32d is, for example, 100 to 40 µm. A width W20 of the via 20 is, for example, 10 to 60 µm.

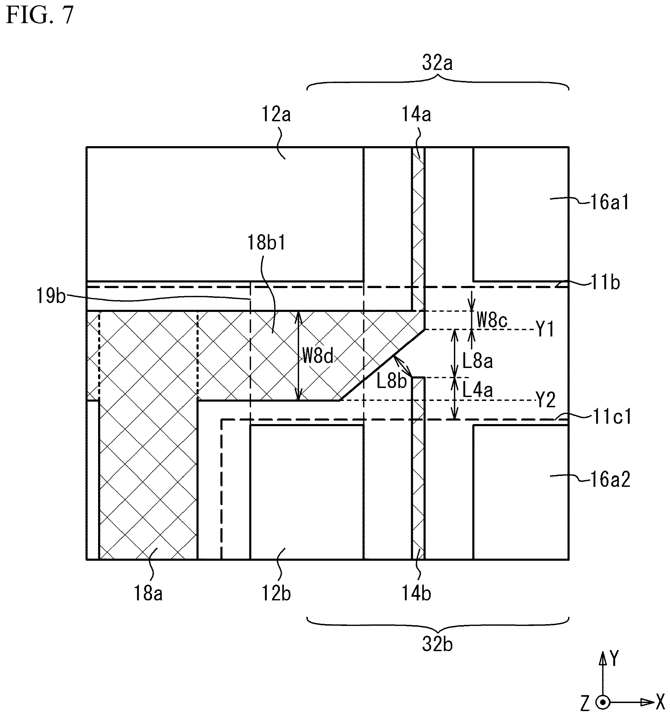

FIG. 7 is an enlarged plan view illustrating the semiconductor device according to the first embodiment. As illustrated in FIG. 7, a width W8c of the gate wiring 18b1 in the Y direction at the first region where the gate finger 14a connects to gate wiring 18b1 is smaller than a width W8d of the gate wiring 18b1 in the Y direction at a second region located between the source fingers 12a and 12b. The width of the gate wiring 18b1 in the Y direction increases linearly toward the -X direction. A distance by which the gate finger 14b protrudes from the active region 11c1 is L4a, a distance in the Y direction between the gate finger 14b and the gate wiring 18b1 is L8a, and a shortest distance between the gate finger 14b and the gate wiring 18b1 is L8b. The width W8c is, for example, 1 µm to 5 µm, and the width W8d is, for example, 5 µm to 20 µm. A distance L4a is, for example, 1 µm to 10 µm, and distances L8a and L8b are, for example, 5 µm to 20 µm.

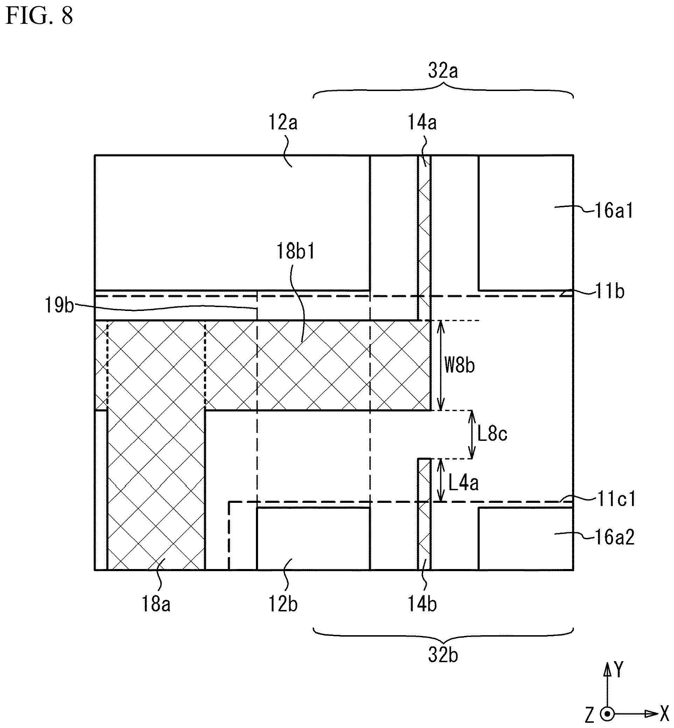

FIG. 8 is an enlarged plan view illustrating the semiconductor device according to a first comparative example. As illustrated in FIG. 8, in the first comparative example, a planar shape of the gate wiring 18b1 is rectangular. A width of the gate wiring 18b1 is W8b, a distance by which the gate finger 14b protrudes from the active region 11c1 is L4a, and a distance in the Y direction between the gate finger 14b and the gate wiring 18b1 is L8c.

In FIGs. 1 and 6, when a high frequency signal is input to the gate bus bar 22, the high frequency signal is supplied from the gate bus bar 22 to the gate fingers 14b and 14d. High frequency signals are supplied from the gate bus bar 22 to the gate fingers 14a and 14c through the gate wirings 18a, 18b1 and 18b2, respectively. When the gate wirings 18b1 and 18b2 are connected to the gate fingers 14b and 14d, the high frequency signals are supplied from the gate wirings 18b1 and 18b2 to the gate fingers 14b and 14d, respectively. As a result, the high frequency signals supplied to the gate fingers 14b and 14d from the gate bus bar 22 and the high frequency signals supplied to the gate fingers 14b and 14d from the gate wiring 18b 1 and 18b2 are different from each other in phases. This causes an increase in losses or the like, and degrades the high frequency characteristics.

In the first embodiment, the gate wirings 18b 1 and 18b2 are not connected to the gate fingers 14b and 14d, respectively. Thereby, the high frequency signals are not supplied from the gate wirings 18b 1 and 18b2 to the gate fingers 14b and 14d, respectively. Therefore, the deterioration of the high frequency characteristics can be suppressed. The first ends (-Y side ends) of the gate fingers 14b and 14d are connected to the gate bus bar 22, and the second ends (+Y side ends) thereof are separated from the gate wirings 18b 1 and 18b2. Thereby, a phase difference occurs between the gate signals supplied from the gate bus bar 22 to the gate fingers 14b and 14d and the gate signals supplied from the gate wirings 18a, 18b 1 and 18b2 to the gate fingers 14a and 14c. However, the gate signals are supplied to the gate fingers 14a to 14d from the same -Y direction, and signals are output from the drain fingers 16a and 16b in the +Y direction. This can suppress the loss due to the phase difference. Therefore, the high frequency characteristics can be improved.

The gate finger 14b protrudes from the active region 11c1 by the distance L4a. When the gate wiring 18b 1 and the gate finger 14b are close to each other, the high frequency signal transmitted through the gate wiring 18b 1 leaks into the gate finger 14b, resulting in the degradation of the high frequency characteristics. To suppress this, the gate wiring 18b 1 and the gate finger 14b are separated by the distance L8c. The gate wiring 18b1 and the active region 11c1 are separated by a distance L4a + L8c. This will increase the size of the substrate 10.

According to that first embodiment, as illustrated in FIG. 7, the width W8c of the gate wiring 18b 1 in the Y direction at the first region where the gate finger 14a connects to the gate wiring 18b 1 is smaller than the width W8d of the gate wiring 18b 1 in the Y direction at the second region located between the source fingers 12a and 12b. An end Y1 of the first region near the gate finger 14b (-Y side) in the Y direction is located closer to the gate finger 14a (+Y side) than an end Y2 of the second region near the gate finger 14b (-Y side) in the Y direction. Thereby, even if the distances L8a and L8b between the gate wiring 18b1 and the gate finger 14b are secured to the same extent as the distance L8c in the first comparative example, the active region 11c1 can be brought closer to the gate wiring 18b1. Therefore, the area of the substrate 10 can be reduced, and the semiconductor device can be reduced in size. When the area of the substrate 10 is the same in the first comparative example and the first embodiment, the width Wgb of the active region 11c1 in the Y direction can be increased in the first embodiment, compared to the first comparative example. Therefore, the output can be increased. From the viewpoint of reduction in size, the width W8c is preferably 2/3 or less of the width W8d, and more preferably 1/2 or less of the width W8d.

In the first comparative example, it is also conceivable to reduce the width W8b. However, if the width W8b is reduced, the resistance of the gate wiring 18b1 becomes high and the high frequency characteristics deteriorate. In the first embodiment, since the width W8d of the gate wiring 18b1 can be increased, the resistance of the gate wiring 18b1 can be lowered and the degradation of the high frequency characteristics can be suppressed.

Further, when viewed from the X direction, a part of the gate finger 14b and a part of the gate wiring 18b1 overlap each other. In other words, a +Y end of the gate finger 14b is located between the ends Y1 and Y2. This allows the active region 11c1 to be brought closer to the gate wiring 18b 1. Therefore, the semiconductor device can be further reduced in size.

As illustrated in FIG. 1 and 6, the gate fingers 14b and 14d are connected to the gate bus bar 22. The gate wiring 18a (a second gate wiring) connects the gate wirings 18b1 and 18b2 to the gate bus bar 22. In this case, when the gate finger 14b connects to the gate wiring 18b1, the high frequency characteristics are degraded. Therefore, if the gate finger 14b and the gate wiring 18b1 are separated, the semiconductor device increases in size as in the first comparative example. Therefore, as illustrated in FIG. 7, it is preferable to make the width W8c of the gate wiring 18b1 smaller than the width W8d.

As illustrated in FIGs. 1 and 6, the gate wiring 18a and the gate finger 14b sandwiches the source finger 12b. Thereby, the gate wiring 18a and the source finger 12b do not overlap in a plan view. Therefore, a gate-source capacitance can be suppressed and the high frequency characteristics can be improved.

The width W2a of the source finger 12a in the X direction may be designed to be wide. For example, a source inductance can be reduced by supplying a source potential to the source finger 12a by the via 20. However, the width W2a of the source finger 12a becomes wider. On the other hand, the width W2b of the source fingers 12b and 12c for supplying the source potential in the Y direction does not have to be as wide as the width W2a. Therefore, as illustrated in FIG. 1, the width W2b of the source finger 12b is smaller than the width W2a of the source finger 12a, and the width W8a of the gate wiring 18a in the X direction is within the width W2a of the source finger 12a. That is, when viewed from the Y direction, the gate wiring 18a, the source finger 12b and 12c overlap the source finger 12a and do not overlap the regions other than the source finger 12a. Thereby, even if the gate wiring 18a is provided, the width of the semiconductor device in the X direction can be suppressed. Therefore, the semiconductor device can be reduced in size.

The via 20 penetrates the substrate 10 and connects the source finger 12a to the metal layer 28 provided under the substrate 10. When the via 20 is directly connected to the source finger 12a in this way, the width W2a of the source finger 12a becomes wider. Therefore, the gate wiring 18a can be provided between the source fingers 12b and 12c.

The source wiring 19b connects the source finger 12a to the source finger 12b and intersects the first gate wiring 18b 1 in a non-contact manner. Thereby, the source fingers 12a and 12b are electrically connected to each other, and the high frequency signal can be supplied from the gate wiring 18b1 to the gate finger 14a.

The substrate 10 includes the active region 11b in which the semiconductor layer 10b inside the substrate 10 is activated, the active region 11c1 in which the semiconductor layer 10b inside the substrate 10 is activated, and the inactive region 11a provided between the active regions 11b and 11c1 and in which the semiconductor layer 10b is deactivated. The active region 11b and the active region 11c1 are separated from each other. The source finger 12a, the gate finger 14a and the drain finger 16a1 are provided on the active region 11b. The source finger 12b, the gate finger 14b and the drain finger 16a2 are provided on the active region 11c1. The gate wiring 18b1 is provided on the inactive region 11a. Thereby, a gate-source capacitance due to the gate wiring 18b1 can be reduced, and the high frequency characteristics can be improved.

As illustrated in FIG. 6, also in the FETs 32c and 32d, the width of the gate wiring 18b2 in the Y direction at a third region where the gate finger 14c connects to the gate wiring 18b2 is smaller than the width of the gate wiring 18b2 in the Y direction at a fourth region located between the source finger 12a and the source finger 12c. An end of the third region near the gate finger 14d (-Y side) in the Y direction is located closer to the gate finger 14c than an end of the fourth region near the gate finger 14d (-Y side) in the Y direction. Thereby, the semiconductor device can be reduced in size.

### (FIRST VARIATION OF FIRST EMBODIMENT)

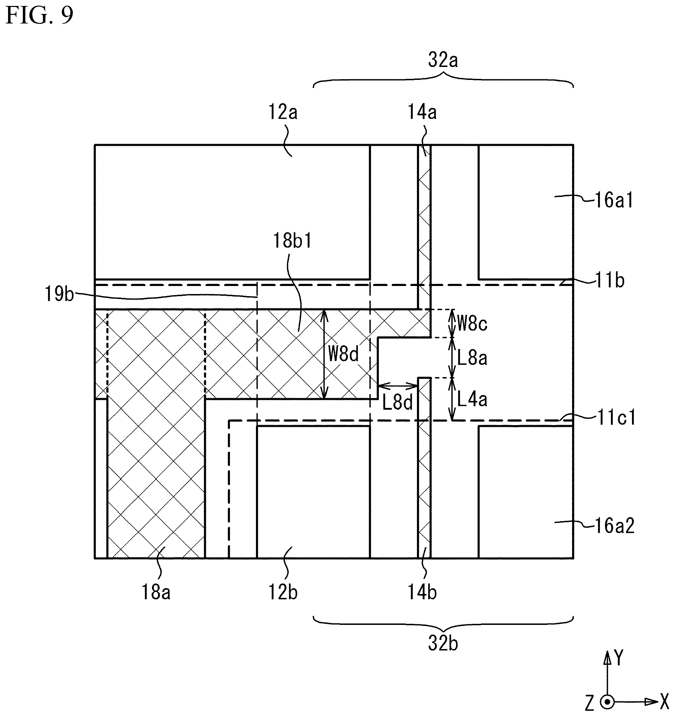

FIG. 9 is an enlarged plan view illustrating the semiconductor device according to a first variation of the first embodiment. As illustrated in FIG. 9, the width W8c in the Y direction of a portion on a + X side of the gate wiring 18b1 is constant, and the width W8d in the Y direction of a portion on the - X side is constant. A distance in the X direction between the gate finger 14b and the gate wiring 18b1 is L8d. The same applies to the gate wiring 18b2. Other configurations are the same as those in the first embodiment, and the description thereof will be omitted. Also in the first variation of the first embodiment, by setting the distance L8d to be about the same as the distance L8a, it is possible to suppress the leakage of the high frequency signal from the gate wiring 18b1 to the gate finger 14b. Moreover, the semiconductor device can be reduced in size.

### (SECOND VARIATION OF FIRST EMBODIMENT)

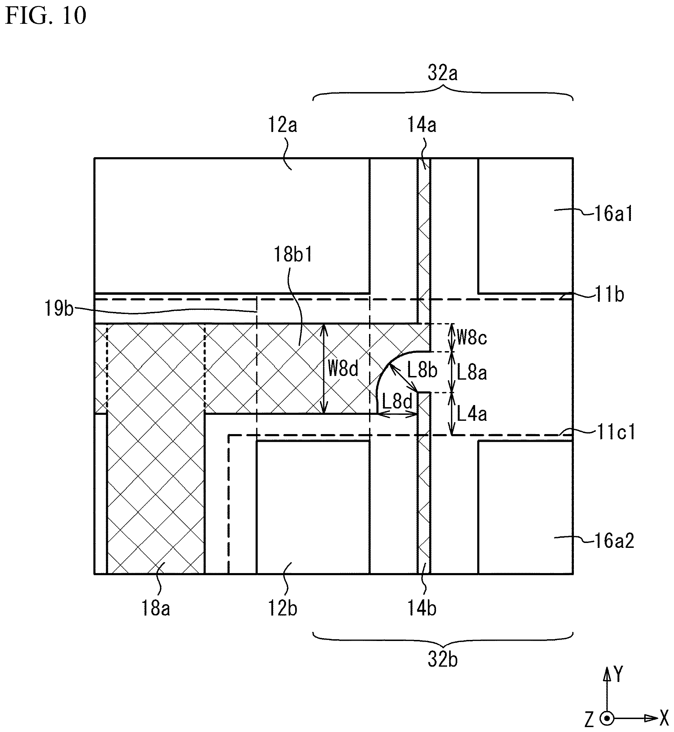

FIG. 10 is an enlarged plan view illustrating the semiconductor device according to a second variation of the first embodiment. As illustrated in FIG. 10, the width of the gate wiring 18b1 increases curvilinearly from the first position where the gate finger 14a is connected to the gate wiring 18b1 toward the - X direction. A side on the - Y side of the gate wiring 18b1 is an outer circumference having a substantially circular centered on an end on the + Y side of the gate finger 14b. Thereby, a shortest distance L8b between the gate finger 14b and the gate wiring 18b1 is substantially the same as the distances L8a and L8d. The same applies to the gate wiring 18b2. Other configurations are the same as those in the first embodiment, and the description thereof will be omitted.

As in the first embodiment and the first variation thereof, the width of the gate wiring 18b1 in the Y direction gradually increases from the first region to the second region. This makes it possible to increase the area of the gate wiring 18b1 and suppress the gate resistance. As in the second variation of the first embodiment, the side on the - Y side of the gate wiring 18b1 is the outer circumference having the substantially circular centered on the end on the + Y side of the gate finger 14b. This makes it possible to increase the area of the gate wiring 18b1 and more suppress the gate resistance.

### (SECOND EMBODIMENT)

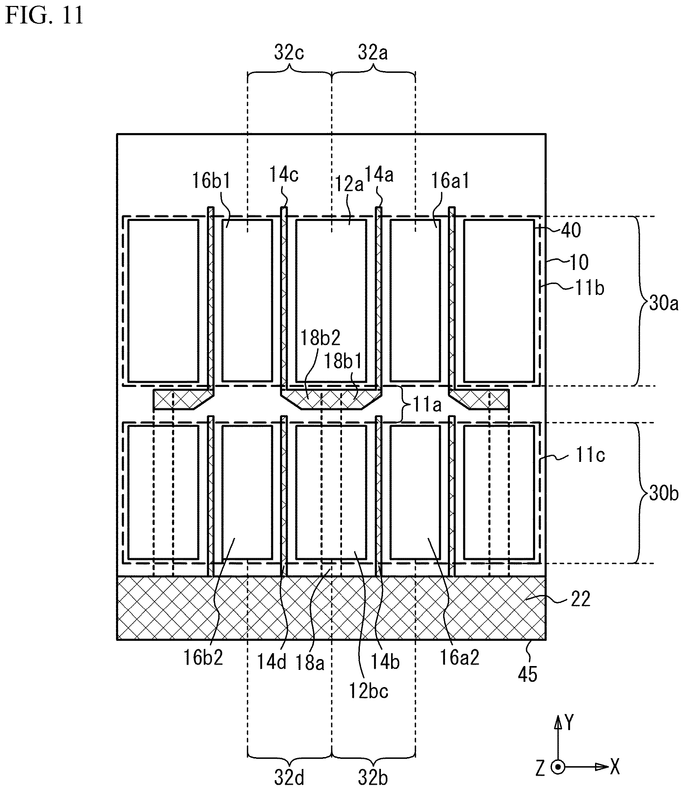

FIG. 11 is a plan view illustrating the active regions, the ohmic metal layer, and the gate metal layer in the semiconductor device according to a second embodiment. As illustrated in FIG. 11, in the second embodiment, the active regions 11c1 and 11c2 (see FIG. 6) are integrated to form an active region 11c. The source fingers 12b and 12c (see Fig. 6) are integrated to form a source finger 12bc. The width of the source finger 12bc in the X direction is substantially the same as the width of the source finger 12a in the X direction. The active region 11c extends in a band shape in the X direction. The gate wiring 18a is formed by the low resistance layer 50, and is provided above the source finger 12bc via the insulating film 26. Other configurations are the same as those in the first embodiment, and the description thereof will be omitted.

As in the second embodiment, the gate wiring 18a may overlap the source finger 12bc in a plan view. In the second embodiment, the gate-source capacity is increased. Therefore, it is preferable that the gate wiring 18a does not overlap the source fingers 12b and 12c in a plan view as in the first embodiment.

In the first and the second embodiments and variations thereof, an example in which four unit FETs are arranged in the X direction is described. However, the number of unit FETs in the X direction may be one, two, three, or five or more. The four unit FETs arranged in the X direction may be regarded as one group, and a plurality of groups may be arranged in the X direction. Although an example in which the single via 20 is provided in the single source finger 12a is described, a plurality of vias 20 may be provided in the single source finger 12a.

The embodiments disclosed here should be considered illustrative in all respects and not restrictive. The present disclosure is not limited to the specific embodiments described above, but various variations and changes are possible within the scope of the gist of the present disclosure as described in the claims.

## Claims

1. A semiconductor device comprising:
a substrate;
a first source finger provided on the substrate;
a first gate finger provided adjacent to the first source finger in a width direction of the first source finger, and on the substrate along the first source finger;
a first drain finger provided on the substrate and sandwiching the first gate finger between the first source finger and the first drain finger;
a second source finger provided on a region of the substrate located in an extension direction of the first source finger from the first source finger, and extending in the extension direction;
a second gate finger provided adjacent to the second source finger in the width direction of the second source finger, on a region of the substrate located in the extension direction from the first gate finger, and along the second source finger;
a second drain finger provided on the substrate and sandwiching the second gate finger between the second source finger and the second drain finger; and
a first gate wiring provided on the substrate, connected to a first end of the first gate finger, not connected to the second gate finger, and extending in the width direction;
wherein a width of the first gate wiring in the extension direction at a first region where the first gate finger connects to the first gate wiring is smaller than a width of the first gate wiring in the extension direction at a second region located between the first source finger and the second source finger, and
an end of the first region near the second gate finger in the extension direction is located closer to the second gate finger than an end of the second region near the second gate finger in the extension direction.

2. The semiconductor device according to claim 1, wherein
a part of the second gate finger and a part of the first gate wiring overlap each other when viewed from the width direction.

3. The semiconductor device according to claim 1 or 2, wherein
the width of the first gate wiring in the extension direction gradually increases from the first region to the second region.

4. The semiconductor device according to any one of claims 1 to 3, further comprising:
a gate bus bar provided on the substrate and to which the second gate finger is connected; and
a second gate wiring connecting the first gate wiring to the gate bus bar and extending in the extension direction.

5. The semiconductor device according to claim 4, wherein
the second gate wiring and the second gate finger sandwich the second source finger.

6. The semiconductor device according to claim 5, wherein
a width of the second source finger is smaller than a width of the first source finger, and
a width of the second gate wiring in the width direction is within the width of the first source finger.

7. The semiconductor device according to claim 6, further comprising:
a via penetrating the substrate and connecting the first source finger to a metal layer provided under the substrate.

8. The semiconductor device according to any one of claims 1 to 7, further comprising:
a source wiring connecting the first source finger to the second source finger, and intersecting the first gate wiring in a non-contact manner.

9. The semiconductor device according to any one of claims 1 to 8, wherein the substrate includes a first active region in which a semiconductor layer inside the substrate is activated, a second active region in which the semiconductor layer inside the substrate is activated, the first active region and the second active region being separated from each other, and an inactive region provided between the first active region and the second active region and in which the semiconductor layer is deactivated,
the first source finger, the first gate finger, and the first drain finger are provided on the first active region,
the second source finger, the second gate finger, and the second drain finger are provided on the second active region, and
the first gate wiring is provided on the inactive region.

10. The semiconductor device according to claim 8 or 9, further comprising:
a third gate finger provided adjacent to the first source finger in a width direction of the first source finger, on the substrate along the first source finger, and sandwiching the first source finger between the first gate finger and the third gate finger;
a third drain finger provided on the substrate and sandwiching the third gate finger between the first source finger and the third drain finger;
a third source finger provided on the substrate, having a width smaller than the width of the first source finger, the width in the width direction being within the width of the first source finger, provided on the same side as the second source finger with respect to the first source finger, and extending in the extension direction;
a fourth gate finger provided adjacent to the third source finger in the width direction of the third source finger, on a region of the substrate located in the extension direction from the third gate finger, and along the third source finger;
a fourth drain finger provided on the substrate and sandwiching the fourth gate finger between the third source finger and the fourth drain finger; and
a third gate wiring provided on the substrate, connected to the first end of the third gate finger, not connected to the fourth gate finger, and extending in the width direction;
wherein a width of the third gate wiring in the extension direction at a third region where the third gate finger connects to the third gate wiring is smaller than a width of the third gate wiring in the extension direction at a fourth region located between the first source finger and the third source finger, and
an end of the third region near the fourth gate finger in the extension direction is located closer to the third gate finger than an end of the fourth region near the fourth gate finger in the extension direction.
